Europäisches Patentamt

European Patent Office

Office européen des brevets

(11) Publication number: **0 405 256 A1**

# EUROPEAN PATENT APPLICATION

(21) Application number: 90111342.3

(22) Date of filing: 15.06.90

(51) Int. Cl.5: **H01L 21/311, H01L 21/321**

(30) Priority: 27.06.89 IT 2099989

(43) Date of publication of application:
02.01.91 Bulletin 91/01

(84) Designated Contracting States:
**DE FR GB NL SE**

(71) Applicant: SGS-THOMSON
MICROELECTRONICS S.p.A.
Via C. Olivetti, 2
I-20041 Agrate Brianza (MI)(IT)

(72) Inventor: **Colombo, Lucio**
Via Adda, 14
I-24045 Fara Gera d'Adda - Bergamo(IT)
Inventor: **Iazzi, Nadia**
Via Casalmaggiore, 61
I-26100 Cremona(IT)

(74) Representative: **Perani, Aurelio et al**
c/o JACOBACCI-CASETTA & PERANI 7, Via
**Visconti di Modroneone**
I-20122 Milano(IT)

(54) A method of hatching micrometric contacts in semiconductor electronic devices.

(57) A method of hatching micrometric contacts in semiconductor electronic devices (1) having at least one intermediate dielectric layer (4), comprises the following steps:
dry etching in a partially isotropic way, the dielectric layer, under an atmosphere of carbon tetrafluoride, using a photoresist removing apparatus which operates under a high pressure gas-discharge plasma; subsequent etching under reactive ionic plasma, in two respectively high and low selectively, steps with the photoresist, until the contact is hatched.

Fig. 3

This invention relates to a method of hatching micrometric contacts in semiconductor electronic devices having at least one intermediate dielectric layer.

It is a well-recognized fact that a particularly critical step in the manufacturing process of very high integration, semiconductor electronic devices, is the contact hatching step.

During that step of the manufacturing process, there is a need to maintain close dimensional control of the contact hatching, so as not to affect the operability of the devices, and especially to maintain a minimum critical distance between the contacts and the gating region of CMOS devices formed by VLSI technology at 0.8 micrometers.

To meet this demand, the prior art currently proposes a fully isotropic etching method which is applied dry in purposely provided equipment operating with radical chemical species.

Known in the trade are, for instance, apparatus of the TOKUDA CDE8 type which constitute so-called downstream etching systems and enable effectuation of isotropic attacks of the round-etch type.

This processing method according to the prior art is, however, ineffective to observe the above-noted critical contact-to-gate distance in devices formed with 0.8-micrometer technology.

In fact, with such methods, an attack is achieved with lateral erosions of the contact gap having the same depth as the vertically directed attack. In essence, the degree of isotropy (As), expressed as the ratio of the vertical and lateral etching rates, in micrometric contact hatching processes is equal to 1 according to the prior art.

This means that an attack extended in the dielectric layer to a depth of 3000 Ångstroms will result in concurrently widening the contact gap diametrically by approximately 6000 Ångstroms, which is unacceptable with a 0.8-micrometer technology of CMOS components.

The technical problem that underlies this invention is to provide a novel method of hatching micrometric contacts which has such characteristics as to enable the gap profile to be controlled, and particularly so the contact base, thereby obviating the above-noted drawbacks with which the prior art is beset.

This problem is solved by a method as indicated being characterized in that it comprises the steps of,
partially isotropically dry etching the dielectric layer, under an atmosphere of carbon tetrafluoride, using an apparatus for removing photoresist which operates under a high pressure gas-discharge plasma, and
subsequently etching under ionic reactive plasma until the contact is fully hatched.

The features and advantages of the method according to this invention will be made apparent by the following detailed description of an exemplary embodiment thereof, shown by way of illustration and not of limitation in the accompanying drawings.

In the drawings:
Figure 1 shows schematically a semiconductor electronic device whereto the inventive method is being applied;
Figure 2 shows schematically the device of Figure 1 subsequently to applying the first step of the inventive method thereto;
Figure 3 is a further schematical representation of the device shown in Figure 1, subsequently to completing the second step of this method; and
Figure 4 is a schematic elevation view of an apparatus for implementing the steps of the inventive method.

With reference to the drawing views, generally and schematically shown at 1 is the structure of a semiconductor electronic device comprising a substrate 2 of a so-walled silicon wafer 7.

The substrate 2 may be monocrystalline silicon or a layer grown, or deposited, on the wafer during a previous manufacturing step of the device 1.

The structure 1 is, in this particular case, that of an EPROM-type memory formed by depositing, on the substrate 2, a first semiconductor layer with predetermined doping wherein active areas, not shown because conventional, are defined, and over which is an intermediate dielectric layer 4.

The dielectric layer 4 is overlaid by a masking layer 5 in which gaps 6 are defined for the contacts by means of a conventional lithographic photoengraving process.

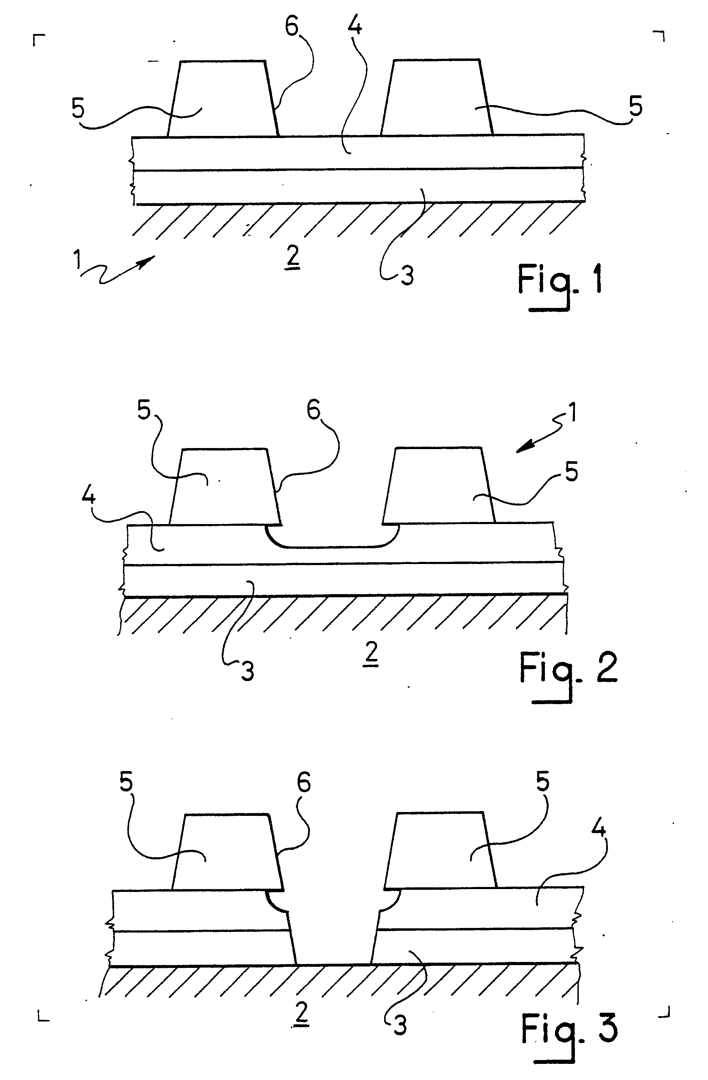

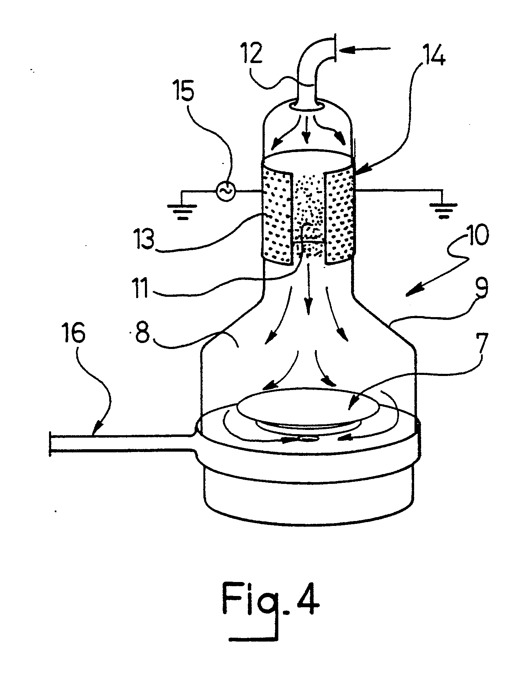

The method will be now described for hatching micrometric contacts according to the invention, starting with an initial state as shown in Figure 1 and using the apparatus of Figure 4.

The first step of the method according to the invention consists of partially isotropically dry etching the dielectric layer 4 as accessible through each of the gaps 6.

Such etching is carried out under a carbon tetrafluoride and oxygen atmosphere on a photoresist removing apparatus 10, shown in Figure 4, known in the trade as BRANSON L3200.

This apparatus 10 consists of a flask 9 having a neck portion 11 which tapers upwards and is in fluid communication with a reservoir of said process gases wia an intake conduit 12.

The flask 9 has a first portion, corresponding to the neck 11, wherein oppositely located electrodes 13 and 14 are accommodate to generate a plasma or so-called free radical-ions from the gas admitted into the flask. Such electrodes are connected to a source 15 of RF voltage.

The flask 9 has a second, lower processing portion 8 wherein the silicon wafer 7 to be processed is accommodated and to which a plasma exhaust conduit 16.

According to the prior art, this apparatus 10 is usually employed to remove surface layers of photoresist by a plasma etching technique based on blasts of partially ionized oxygen under a low pressure.

According to the invention, on the other hand, this apparatus is operated under an atmosphere of carbon tetrafluoride ($CF_4$) and oxygen ($O_2$) within a comparatively high pressure range of 1000 to 3000 mtorrs, and with a discharge power of 200 to 300 watts from the source 15.

By controlling the discharge composition, specifically the ration of ions and radicals thereof, it becomes possible to control the degree of isotropy of the attack to the dielectric layer 4.

The following steps of the method according to the invention consist of an attack under reactive ionic plasma (RIE), in two respective high- and low-selectivity steps, toward the photoresists.

The first step of the reactive ionic attack with molecular gas is performed under an atmosphere of di-methyl tri-fluoride ($CHF_3$) and oxygen, in a ratio of 7:15, and at a discharge power in the 2000 to 3000 watt range and a pressure within the 40 to 80 mtorrs.

The last, low-selectively step is carried out under the same processing condition of discharge but at a ratio of 1:3 of said gases.

The method of this invention is highly advantageous in that it can ensure a uniquely accurate control of the contact seat. This makes it unnecessary to use techniques for smoothing the contact profile, to be possibly applied subsequent to the contact hatching, presently unsuited to the high degree of integration of semiconductor electronic devices.

Another major advantage of the inventive method is that contacts can now be formed whose dimensions suit the contact-to-gate distances required of devices made with the VLSI technologie at 0.8 micrometers.

## Claims

1. A method of hatching micrometric contacts in semiconductor electronic devices (1) having at least one intermediate dielectric layer (4), comprising the steps of,
partially isotropically dry etching the dielectric layer (4), under an atmosphere of carbon tetrafluoride, using an apparatus (10) for removing photoresist which operates under a high pressure gas-discharge plasma, and

subsequently etching under reactive ionic plasma until the contact is fully hatched.

2. A method according to Claim 1, characterized in that said subsequent etching step under reactive ionic plasma is carried out in two, respectively high and low selectivity, steps with the photoresist.

3. A method according to Claim 1, characterized in that said discharge is performed within a pressure range of 1000 to 3000 mtorrs and a power range of 200 to 300 watts.

Fig. 1

Fig. 2

Fig. 3

Fig. 4

## European Patent Office

# EUROPEAN SEARCH REPORT

Application Number

EP 90 11 1342

| | DOCUMENTS CONSIDERED TO BE RELEVANT | | |
|---|---|---|---|
| Category | Citation of document with indication, where appropriate, of relevant passages | Relevant to claim | CLASSIFICATION OF THE APPLICATION (Int. Cl.5) |
| X | EP-A-0 282 820 (SIEMENS AG) <br> * column 3, line 47 - column 5, line 11; claims 1,4,5; figure * | 1 | H 01 L 21/311 <br> H 01 L 21/321 |
| A | | 3 | |
| | --- | | |
| X | PATENT ABSTRACTS OF JAPAN <br> vol. 10, no. 263 (E-435), 9 September 1986; & JP - A - 61 089635 (TOSHIBA CORP.) 07.05.1986 * the whole document * | 1 | |
| Y | idem | 2,3 | |
| | --- | | |
| Y | PATENT ABSTRACTS OF JAPAN <br> vol. 11, no. 343 (E-555), 10 November 1987; & JP - A - 62 123760 (NEC CORP.) 05.06.1987 | 2 | |
| | --- | | |
| Y | US-A-4 502 915 (D.E. CARTER et al.) <br> * column 2, line 46 - column 3, line 29; figure A * | 3 | |
| | --- | | TECHNICAL FIELDS SEARCHED (Int. Cl.5) |
| X | PROCEEDINGS OF THE 4TH INTERNATIONAL IEEE VLDI MULTILEVEL INTERCONNECTION CONFERENCE <br> 15,16 June 1987, pages 298-305, Santa Clara, CA, US; V. GREWAL et al.: "Contact hole and via profiling by high rate isotropic and anisotropic etching of oxides" * pages 298,299; page 300, paragraph "experimental"; figure 3 * | 1 | H 01 L |
| | --- | | |
| X | US-A-4 495 220 (S. WOLF et al.) <br> * column 4, lines 7-38; figures 1d,e * | 1 | |
| A | ---         -/- | 2,3 | |

The present search report has been drawn up for all claims

| Place of search | Date of completion of the search | Examiner |
|---|---|---|
| BERLIN | 17-08-1990 | KLOPFENSTEIN P R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)

European Patent
Office

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | DE-A-2 929 060 (SIEMENS AG) <br> * page 5, line 18 - page 6, line 33; figure * <br> ----- | 1,3 | |
| | | | **TECHNICAL FIELDS SEARCHED (Int. Cl.5)** |

The present search report has been drawn up for all claims

| Place of search | Date of completion of the search | Examiner |
|---|---|---|
| BERLIN | 17-08-1990 | KLOPFENSTEIN P R |